# EUROPEAN PATENT APPLICATION

(11) **EP 2 216 829 A1**
(43) Date of publication of application: **11.08.2010**
(21) Application number: 09001877.1
(22) Date of filing: 10.02.2009
(51) Int. Cl.: H01L 31/048

(54) **Solar roof tile assembly**

(71) Applicant: Darvan Invest N.V., 8850 Ardooie (BE)
(72) Inventor: Deneire, Michel, 8850 Ardooie (BE)
(74) Representative: BiiP cvba

(57) **Abstract**

The present invention is directed to a roof tile assembly comprising a support structure for supporting at least one photovoltaic panel, said support structure comprising at least one housing block, **characterized in that** said housing block comprises at least one busbar for providing electrical connection.

The present invention is also directed to a busbar structure for electrically connecting one or more roof tile assemblies, said busbar structure comprising a first rigid conductive circuit member, integrated in a first roof tile assembly, a second rigid conductive circuit member, integrated in a second roof tile assembly, and at least a third conductive circuit member connected to an electrical generating device, **characterized in that** said first rigid conductive circuit member and said second rigid conductive circuit member are adapted for engaging to each other. The present invention is also directed to the use of at least one busbar structure in a roof tile assembly.

## Description

### FIELD OF THE INVENTION

The present invention relates to the field of solar power, in particular solar roof tile assemblies. The present invention also relates to a busbar structure for electrically connecting roof tile assemblies.

### BACKGROUND OF THE INVENTION

Renewable energy offers our planet a chance to reduce carbon emission, clean the air, and put our civilization on a more sustainable footing. It also offers countries around the world the chance to improve their energy security and spur economic development. The fastest growing energy technology in the world is grid-connected solar photovoltaics (PV), with 50% annual increases in cumulative installed capacity in both 2006 and 2007, to an estimated 7.7 GW. This translates into 1.5 million homes with rooftop solar PV feeding into the grid worldwide.

The widespread use of photovoltaic systems mounted to homes, businesses and factories is generally considered to be a desirable goal. Several factors are believed to be critical to the acceptance of PV systems, in particular by the individual homeowner. Primary among the factors are efficiency, cost and aesthetics. The present invention is a key resource to underpin these developments.

At present several solar roof tile assemblies are known for converting solar energy into electrical power. A drawback of many types of solar roof tile assemblies is that electrical connection between the different roof tile assemblies is based on electrical wires. During installation wire mixing can occur and can cause connection problems. Moreover, placement of roof tile assemblies comprising electrical wires does not allow the placer to reduce its time on the roof of a house. Tracing a defect in a cable-system requires the technician to detangle the different electrical wiring before the fixing can start. Removal and replacement of cables is a difficult and cumbersome work at roof height. An example of such a solar roof tile assembly is presented in WO2008/052816.

A solution to avoid wire mixing is presented in WO2007/079584. WO'584 provides a modular system that includes a composite tile, with or without integrated photovoltaic cells, a track system for assembly of the tiles to a structure, and a wiring system for the photovoltaic tile. The track lengths are fastened to the structure. A busbar or wire harness is assembled to the track. When the photovoltaic tile is interlocked with the track, the connectors of the photovoltaic cells engage the busbar or wiring harness to provide an electrical connection.

A drawback of WO2007/079584 is that the installation of an extra support structure for the roof tile on the existing roof structure is a labor demanding work. Installation of a metal track system is time consuming and is a heavy work which requires extra bearing capacity of the roof structure. Further, the track system does not allow the solar roof tiles to be fully integrated with the non-solar part of the roof which is more aesthetically appealing. Costs can be reduced by integrating the photovoltaic cells in traditional roof tiles that do not require an additional installation of a platform or structure on the roof.

Another solution to avoid wire mixing is presented in DE29616015 which describes a roof tile. The roof tile can be produced in various materials and photovoltaic cells can be integrated therein. The electrical connections are embedded in cable shafts that form moisture and ventilation passages.

Although DE29616015 provides cable passages that serve as by-passes for moisture and ventilation, a hurdle to overcome is oxidation of the electrical contacts. The air current passing through the cable shafts beneath the photovoltaic panels contains moisture. The moisture can come into contact with the electrical contact causing corrosion of the electrical contacts. Also, frost can injure the electrical connection. Moreover, as the conduits housing the electrical wires are open at both ends of the roof tile, vermin can easily find its way to the electrical connections, these can gnaw and destroy the cables, leading to short-circuit and possibly to fire.

Given the above drawbacks of existing solar roof tile assemblies, it is a main object of the present invention to provide an optimized solar roof tile assembly with respect to cost of installation, maintenance and efficiency.

It is a particular object of the invention to provide a roof tile assembly that allows easy defect control and wherein the photovoltaic panels and the electrical connections are easily interchangeable without demounting the roof. Thus, wire mixing can be avoided, installation is simple, user friendly, and the time on the roof can be reduced.

It is a further object of the present invention to provide a roof tile assembly that is moisture resistant and therefore will inhibit water to contact the electrical connections that causes corrosion and/or oxidation.

It is also an object of the present invention to provide a solar roof tile assembly that includes cavities allowing natural and/or induced ventilation whereby all contact of the air with the electrical connections is avoided while increasing the efficiency of the photovoltaic panel by cooling it at the back.

Further, it is an object to provide a roof tile assembly whereby costs are reduced by reducing the building materials. In addition, since the roof tile assemblies are an integral part of the design, they generally blend in better and are more aesthetically appealing than other solar options.

The present invention meets the above objects by using a solar roof tile assembly in accordance with the present invention.

### SUMMARY OF THE INVENTION

The present invention is directed to a roof tile assembly comprising a support structure for supporting a photovoltaic panel, said support structure comprising at least one housing block, characterized in that said housing block comprises at least one busbar for providing electrical connection.

The present invention is also directed to a busbar structure for electrically connecting one or more roof tile assemblies, said busbar structure comprising a first rigid conductive circuit member, integrated in a first roof tile assembly, a second rigid conductive circuit member, integrated in a second roof tile assembly, and at least a third conductive circuit member connected to an electrical generating device, characterized in that said first rigid conductive circuit member and said second rigid conductive circuit member are adapted for engaging to each other. The present invention is also directed to the use of at least one busbar structure in a roof tile assembly.

### DESCRIPTION OF THE INVENTION

The present invention is directed to a roof tile assembly comprising a support structure for supporting at least one photovoltaic panel, said support structure comprising at least one housing block, characterized in that sad housing block comprises at least one busbar for providing electrical connection.

The incorporation of at least one housing block comprising at least one busbar in the support structure allows the electrical connection between one or more of the roof tile assemblies and within the roof tile assembly such as to render the electrical connection moisture resistant. The advantage is that the housing block protects the electrical connection against all contact with moisture from the environment and therefore will inhibit water to contact the electrical connections thereby preventing corrosion and/or oxidation.

By positioning the housing block longitudinally in the support structure, contact with moisture from drainage and air current is limited. In contradiction to horizontal positioning of the housing block, the moisture is able to flow down along the slope of the roof.

By means of a snap-shot system the housing block is easily snapped into the support structure, so the placement of the roof tile assembly is very easy and user friendly. Snapping the housing block in the support structure avoids the cumbersome work of wiring, which may cause connection errors. The housing block comprising the busbar is removable from the support structure. Preferably, the photovoltaic panel is removable from the roof tile assembly without demounting the roof. The photovoltaic panel is enclosed in a frame member that can be detached from the support structure and replaced by simply pulling it out of the respective support structure, clicking a new one in the circuit and pressing the new panel into the support structure by means of a snap-shot system. The advantage of using interchangeable photovoltaic panels and electrical connections is that it simplifies control defect. A removable PV panel and interchangeable busbars allows the installation, removal and replacement of these elements to be simplified. In addition, the amount of time on the roof while constructing the roof is reduced.

Preferably, the support structure comprises cavities for natural and/or induced ventilation. These cavities encourage the passage of air directly underneath the photovoltaic panels whereby the PV panels are cooled which increases their efficiency. Through an opening in the support structure of the top roof tile, the air is directed to an evaporator, which can be installed in the inner side of the closed roof top. The heat pump will hence receive warm air from the evaporator. This natural and/or induced ventilation increases the coefficient of performance (COP) of the heat pump with up to 10% and more.

### BRIEF DESCRIPTION OF THE DRAWINGS

FIG 1 schematically represents a part of the roof with two rows of solar roof tile assemblies.
FIG 2 schematically represents a solar roof tile assembly comprising a support structure for supporting a frame member comprising a photovoltaic panel.
FIG 3 schematically represents a sectional view on the roof covered with solar roof tile assemblies.
FIG 4 schematically represents a support structure.
FIG 5 schematically represents the first housing block.
FIG 6 schematically represents the second housing block.
FIG 7 (a) and FIG 7 (b) schematically represents the first busbar.
FIG 8 schematically represents the second busbar.
FIG 9 schematically represents the connection element.
FIG 10 schematically represents the rear side of the frame member of the solar roof tile assembly.
FIG 11 schematically represents the first and second part of the frame member designed to enclose a photovoltaic panel.
FIG 12 schematically represents a cross section of a roof tile assembly comprising a frame member enclosing a photovoltaic panel and illustrates the snap shot system.
FIG 13 schematically represents a busbar structure comprising connection elements and a diode.
FIG 14 schematically represents a cross section of a roof tile assembly comprising a frame member supporting a photovoltaic panel.
FIG 15 schematically represents a support structure with two housing blocks installed.
FIG 16 schematically represents a longitudinal section of a roof tile assembly comprising a frame member supporting a photovoltaic panel.
FIG 17 schematically represents the rear side of a support structure.
FIG 18 schematically represents a single circuit of busbars in the solar roof tile assemblies.
FIG 19 schematically represents a double circuit of busbars in the solar roof tile assemblies.
FIG 20 schematically represents a double circuit of busbars on a roof.
FIG 21 schematically represents the first housing block for a double circuit.
FIG 22 schematically represents the second housing block for a double circuit.
FIG 23 schematically represents a busbar structure comprising connection elements and a diode.
FIG 24 schematically represents a support structure and a closing panel.

### DESCRIPTION OF A PREFERRED EMBODIMENT

According to the present invention, a roof tile assembly for conversion of light into electricity according to the photoelectrical effect is presented, the roof tile assembly comprising a support structure for supporting at least one photovoltaic panel, the support structure comprising at least one housing block, characterized in that said housing block comprises at least one busbar for providing electrical connection.

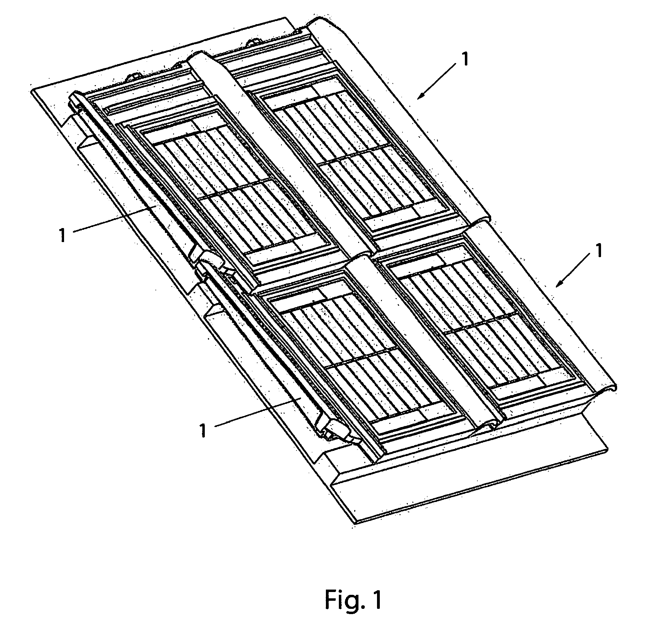

Referring to fig. 1, a part of the roof is presented with two rows of two solar roof tile assemblies 1 thereon.

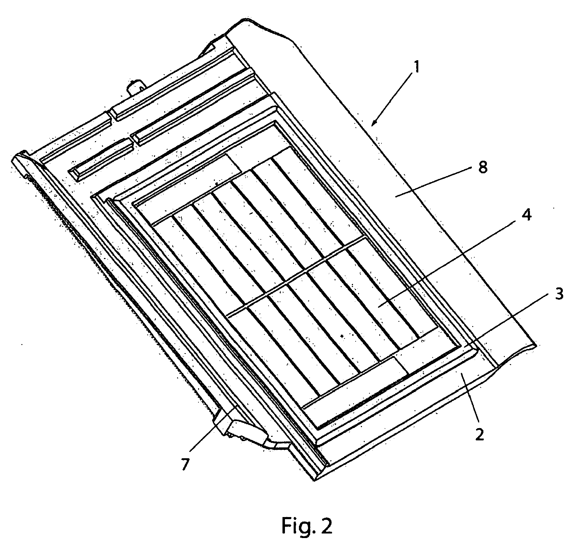

As illustrated in fig. 2, the solar roof tile assembly 1 comprises a support structure 2 for supporting a frame member 3 comprising the photovoltaic panel 4.

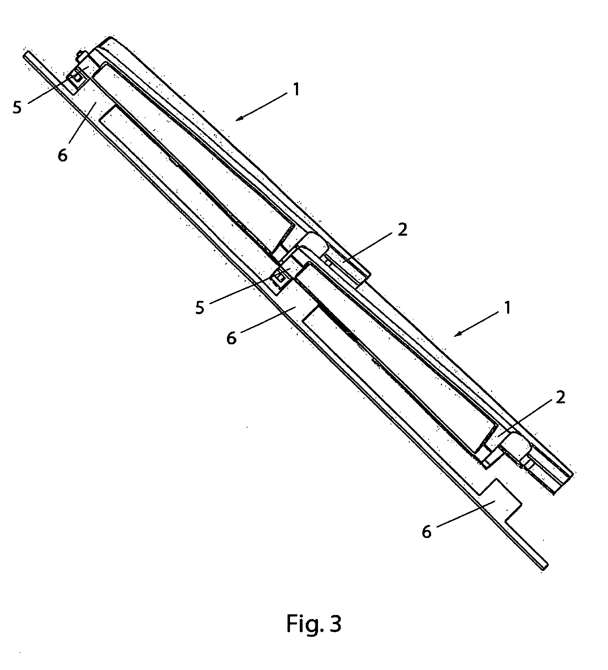

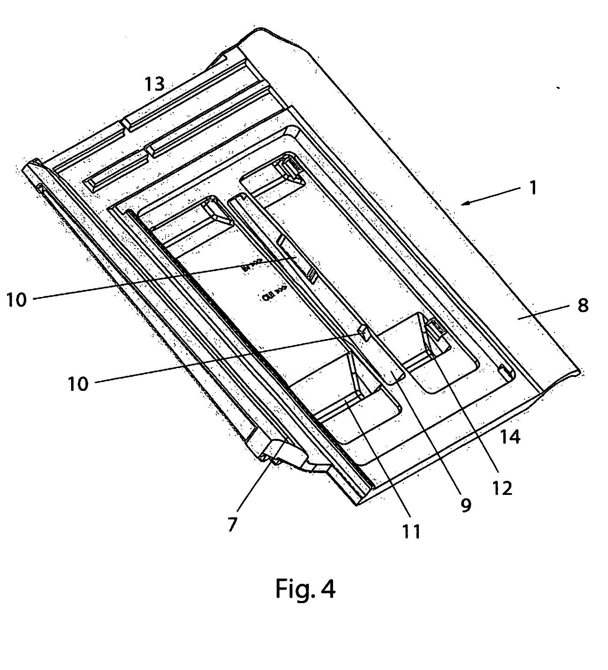

As illustrated in figure 3, the support structure 2 of a roof tile assembly 1 has conventional recurved edges 5 that engage with the structure of the roofing 6. The support structure 2 further comprises a downwardly curving first lateral edge 7 and an upwardly curving second lateral edge 8, illustrated in fig. 2 and 4. Each of these recurved lateral edges 7 and 8 is generally U-shaped. According to figure 4, a recess 9 with notches 10 is located about centrally in the support structure 2. Further, the support structure 2 comprises a first row 11 and a second row of cavities 12 providing two channels between the top 13 and bottom side 14 of the support structure 2.

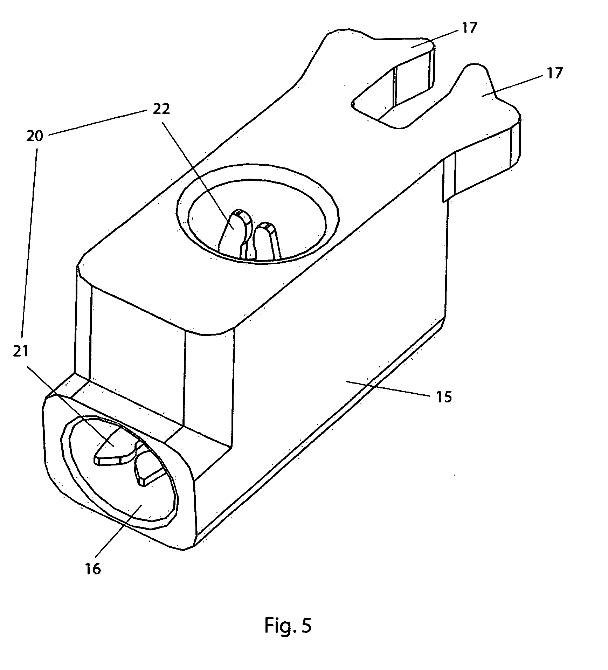

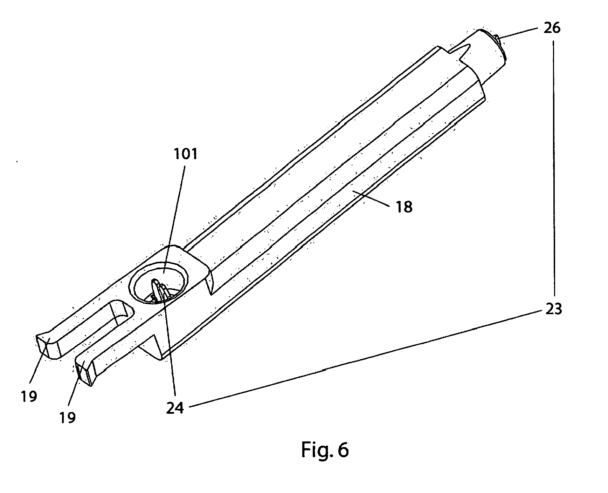

The support structure 2 further comprises a first housing block 15, illustrated in figure 5. The first housing block comprises an elongated cavity 16 and two clips 17. The second housing block 18, illustrated in fig. 6, comprises an elongated cavity 101 and two clips 19.

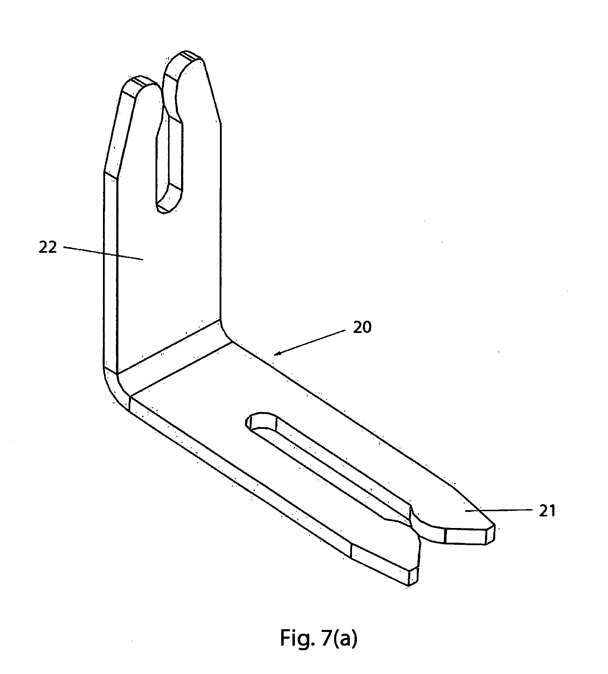

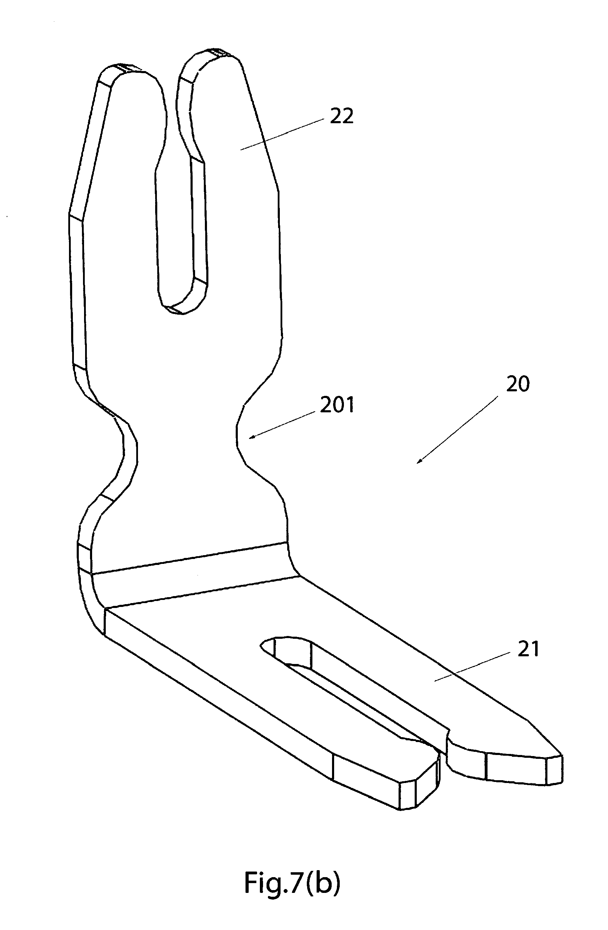

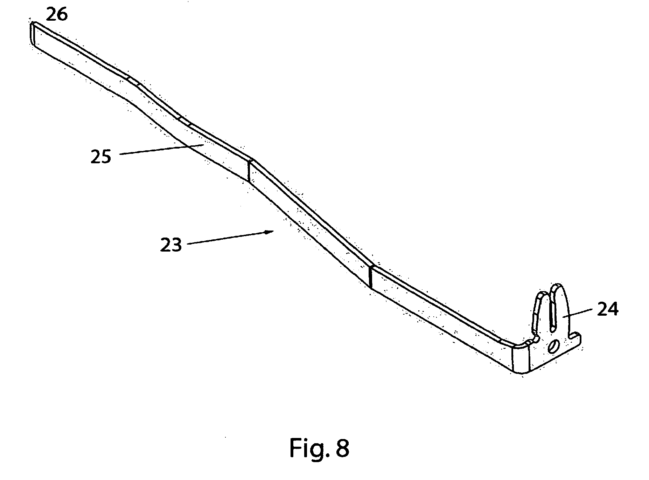

As illustrated in figure 7 (a) and 7 (b), a first busbar 20 is a first rigid conductive circuit member with a fork 21 at one side and a fork 22 at the other side. A second busbar 23, illustrated in figure 8, is a second rigid conductive circuit member comprising a fork 24 at one end and a flexure 25 towards the other end 26.

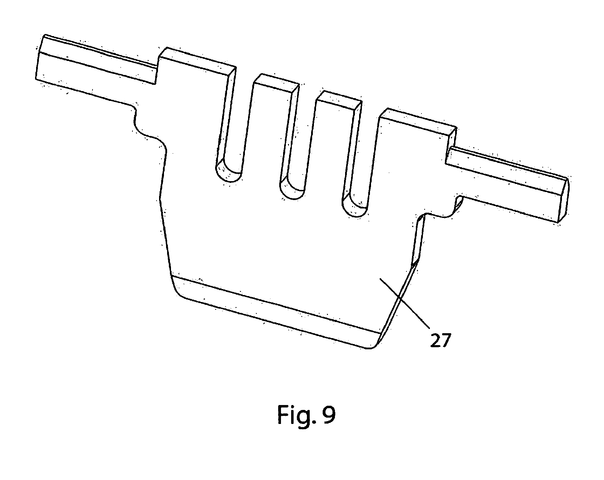

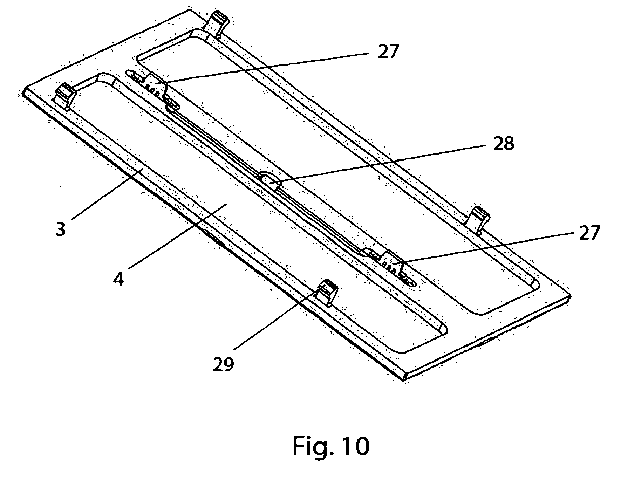

As illustrated in detail in figure 9, a connection element 27 is presented and as shown in figure 10, two connection elements 27 are fixed to the conductive strip (not shown in the figure) at the rear side of the photovoltaic panel 4, one to the positive and one to the negative pole. Preferably, a diode 28 is attached to the rear side of the frame member 3 supporting the photovoltaic panel 4 and is connected between the two connection elements 27.

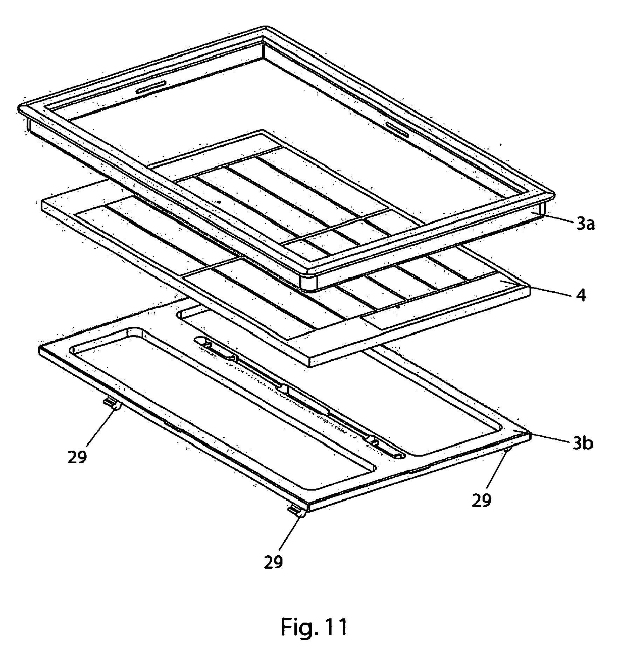

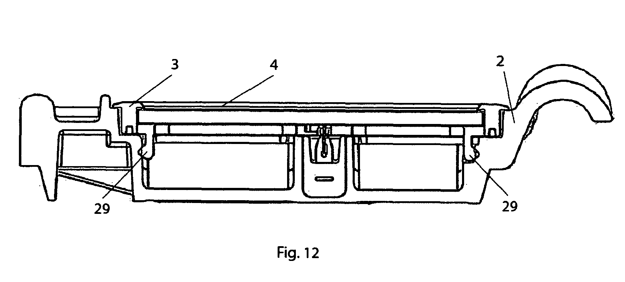

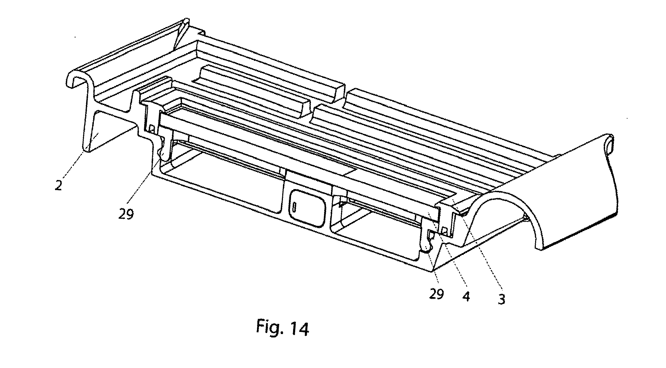

As illustrated in figure 11, the photovoltaic panel 4 is enclosed between two parts 3a and 3b of frame member 3, Part 3b of the frame member 3 comprises clips 29 to attach the frame member 3 in the support structure 2 by means of a snap-shot system, in detail shown in figure 12 and figure 14.

Preferably the busbars 20 and 23 and the connection elements 27 are made of conductive materials, such as (stainless) steel, aluminium, composite materials, materials preferably having a conductive coating, and the like. Preferably, the conductive material has a resistivity lower than 10,0.10⁻⁷Ωm. More preferably, the resistivity is lower than 7,5.1⁻⁷Ωm and even more preferred is a resistivity lower than 7,3.10⁻⁷ΩM. Preferably inox spring steel with a tensile strength of at least 1500N/mm² is used. The inox spring steel ensures certain resilience when the busbars 20 and 23 need to be connected to each other or when they need to be connected to the connection elements 27 attached to the photovoltaic panel 4. At the same time, the tensile strength of the inox spring steel is at least 1500N/mm², so that it takes force to disconnect the busbars 20 and 23 and/or connection elements 27 once they are connected. By providing a coating, oxidation and/or corrosion of the material are reduced, while the surface resistance between the different elements can also be reduced.

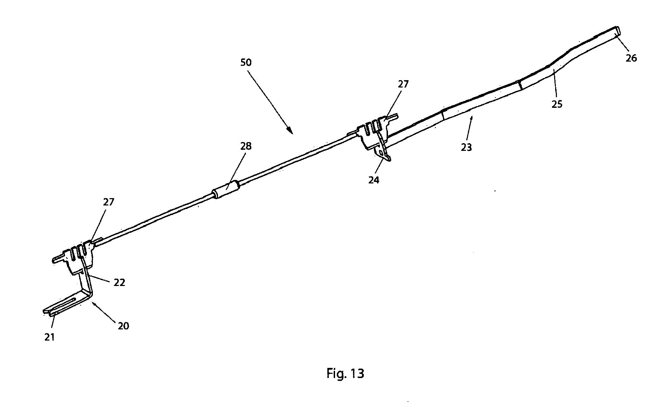

A preferred embodiment connects the first and second busbars 20 and 23 as illustrated in figure 13. The first busbar 20 is connected with the forks 22 to a connection element 27. The fork 24 of the second busbar 23 contacts another connection element 27. Preferably, the connection elements 27 are connected to the first (15), respectively the second (18) housing block via a snap fit, whereby the length of the part of the connection elements 27 received by the housing blocks 15 or 18 is sized so as to minimize movement of the connection elements 27 in the openings of the housing blocks 15 and 18.
In another preferred embodiment, preferably the first busbar 20 can be designed as to allow movement of the conductive element. An elastically, flexible zone 201 allows the busbar 20 to move in its housing block 15 upon shrinking and expansion of the support structure 2 with the changing weather conditions, illustrated in figure 7 (b). The connection elements 27 make physical contact with the conductive strip at the rear side of the photovoltaic panel 4 (not shown in the figure). This series of electrical connection elements, the busbar structure 50, can be repeatedly installed in several roof tile assemblies 1 to make a string to guide the electrical power. Preferably, the busbar structure comprises a diode 28. The diode 28 is included in the circuit to bypass the photovoltaic panel 4 if failure occurs.

In a preferred embodiment, the first busbar 20 is included in the first housing block 15, see also figure 5. The second housing block 18 encloses the second busbar 23, illustrated in figure 6. The inclusion of the first and second busbars 20 and 23 in respectively the first and second housing blocks 15 and 18 offers the advantage that the busbars 20 and 23 are protected from moisture. As such, no oxidation and/or corrosion of the metal electrical connections is possible. In a more preferred embodiment, the busbars 20 and 23 can be coated. In a more preferred embodiment, the recesses 16 and 101 of the respective housing blocks 15 and 18 where the busbars 20 and 23 contact the connection elements 27 of the photovoltaic panel 4 can be additionally sealed with for example, but not limited to non-conductive silicon-based fat or silicones. Additional sealing is also achievable by applying an O-ring or by 2K injection molding of the elements. The additional sealing inhibits moisture to contact the electrical connections. In a preferred embodiment, the different elements of the roof tile assembly, i.e. the support structure 2 and the housing blocks 15 and 18 can be made of water resistant material.

The photovoltaic panel 4 is fixed in the frame member 3 and sealed so it is moisture resistant. Preferably the sealing is done by, but not limited to using silicone-based glue. As illustrated in figure 12 and figure 14, fixing of the frame member 3 comprising the photovoltaic panel 4 in the support structure 2 of the roof tile assembly 1 is done by the clips 29 of the frame member 3 by means of a snap-shot system.

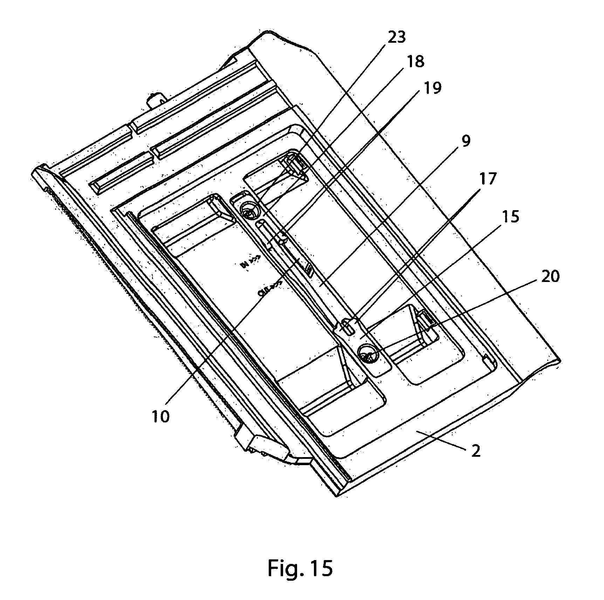

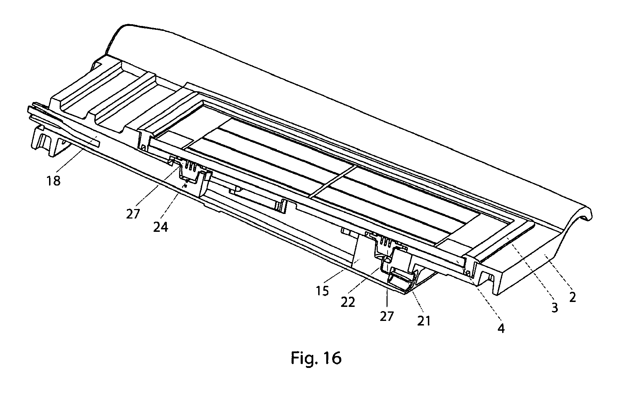

As illustrated in figure 15, two busbars 20 and 23 in housing blocks 15 and 18 are fixed in the support structure 2 to receive the connection elements 27 of the photovoltaic panel 4 in the frame member 3 (not shown in the figure) of the solar roof tile assembly 1. Preferably, the housing blocks 15 and 18 are removable from the support structure 2. The first housing block 15 is snapped into the recess 9 of the support structure 2. The clips 17 of the first housing block 15 are fixed in the notches 10 of the central recess 9 by means of a snap-shot mechanism. The second housing block 18 is snapped towards the other end of the recess 9 of the support structure 2. The clips 19 of the second housing block 18 are snapped into notches 10 of the central recess 9 and than the second housing block 18 is slided towards the following notches 10. As illustrated in figure 16, the fork 22 of the first busbar 20 and the fork 24 of the second busbar 23 are now directed to receive the connection elements 27 attached to the conductive strip on the rear side of the photovoltaic panel 4 (not shown in the figure). Preferably, the connection elements 27 are connected to the first (15), respectively the second (18) housing block via a snap fit, whereby the length of the part of the connection elements 27 received by the housing blocks 15 or 18 is sized so as to minimize movement of the connection elements 27 in the openings of the housing blocks 15 and 18. The support structure 2 is designed so that shrinking and expansion with changing weather conditions is allowed. The first busbar 20 and the second busbar 23 are fixed in their respective housing blocks. The support structure 2 moves in a longitudinal direction around the busbars. The movement of the different circuit members, however, is minimized so the backlash and hence friction of the different elements is reduced. By reducing friction between the different circuit members, wear of the conductive material is also reduced.

In another embodiment of the invention, preferably the first busbar 20 can be designed as to allow movement of the conductive element. An elastically, flexible zone 201 allows the busbar 20 to move in its housing block 15 upon shrinking and expansion of the support structure 2 with the changing weather conditions, illustrated in figure 7 (b). The constriction that defines the flexible, elastically zone 201 is designed so that the conductivity of the circuit member is not influenced.

The support structure 2 of the roof tile assembly 1 serves as the carrier of the frame member 3 mounted on the top side of the support structure 2, as illustrated in figure 2. When the frame member 3 comprising the photovoltaic panel 4 is now pressed on the support structure 2, the clips 29 of the frame member 3 are snapped into the support structure 2, ensuring the solar roof tile assembly 1 to be resistant to difficult weather circumstances, for example a strong wind or changing temperatures. In a preferred embodiment, the clips 29 are broken when the frame member 3 is detached from the support structure 2. In this way, it is not possible to reinstall a defect photovoltaic panel 4.
Further, the forks 22 and 24 of the first and second busbars 20 and 23 are resilient enough to receive the connection elements 27. Preferably, inox spring steel with a tensile strength of at least 1500 N/mm² is used. Hence, some force is needed to install the frame member 3 in the support structure 2. This allows a strong connection between the electrical connection elements present in the roof tile assembly 1.

An advantage of using busbars to connect the plurality of solar roof tile assemblies is that terminals formed on the rear surface of the support structure 2 do no longer need to be connected by electrical wires. This wiring is a very cumbersome work, so power output wires from a plurality of solar roof tile assemblies get tangled together to cause connection errors. Placing the roof tile assemblies comprising busbars in housing blocks, the different assemblies are connected by simply snapping the housing blocks in the roof tile assemblies and than snapping the input of one roof tile assembly in the output of an underlying roof tile assembly.

Further, by using detachable housing blocks that comprise the busbars to connect solar roof tile assemblies in an electrical circuit, defect control is simplified and safer to perform. Demounting of the roof tile assembly is no longer necessary. The removable frame member comprising the photovoltaic panel is snapped out and the removable housing blocks can individually be removed, tested and/or replaced from the support structure. Placement, removal and replacement of the frame member comprising the photovoltaic panel or of the different housing blocks comprising the busbars are simple and user friendly tasks. Moreover, by reducing the time of the technician spent on the roof, the operation is much safer and labor costs can be reduced.

The roof tile assemblies may overlap so that the roof tile assembly is secured against being lifted upwards and to permit water running down from one roof tile assembly. The support structure 2 of a roof tile assembly 1 has conventional recurved edges 7 and 8 to provide weatherproofing and interengagement between adjacent solar roof tile assemblies illustrated in figures 2 and 4. Each of these recurved lateral edges is generally U-shaped. Other conventional or unconventional interengageable edges may be used as well. Specifically, the support structure 2 has profilings 5 that engage with the structure of the roofing 6 and that fixed the tile vertically to the roof, as illustrated in figure 3. A more preferred embodiment of a roof tile assembly comprises clamps to engage with the roof.

Several rows of solar roof tile assemblies are laid upon the roof, as illustrated in figure 1. Adjacent roof tile assemblies are electrically connected by snapping the second housing block 18 with the fork 26 of the second busbar 23 in the support structure 2 of the solar roof tile assembly 1 in the first housing block 15 with the fork 21 of the first busbar 20 of the solar roof tile assembly that is placed above the solar roof tile assembly 1. By placing the roof tile assemblies from the gutter upwards to the top of the roof, this operation is repeated several times and several rows of roof tile assemblies 1 can be easily connected.

Preferably, the housing blocks 15 and 18 are positioned longitudinally in the support structure 2, contact with moisture from drainage and air current is limited. In contradiction to horizontal positioning of the housing block, the moisture is able to flow down along the slope of the roof.

In a preferred embodiment, the water resistancy of the housing blocks 15 and 18 is provided by an additionally sealing component. Preferably, the sealing component includes, but is not limited to non-conductive silicone-based fat or silicones. By pressing the first and second housing block 15 and 18 against each other, the silicon-based fat or silicones at the end of the housing blocks 15 and 18 forms an additional sealing within the housing blocks 15 and 18 and at the connection side of the first and second housing block 15 and 18. By using the extra sealing component, moisture can under no circumstances penetrate the housing blocks at the site of connection of one housing block to the other. Preferably, the closure of the connection pieces can be made by 2K injection molding, which will increase water resistancy. An O-ring can also be used as additionally sealing technique.

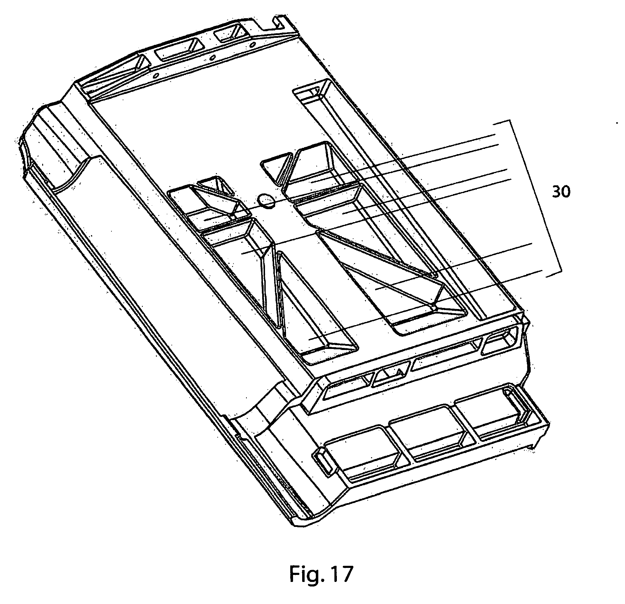

A preferred roof tile assembly according to the invention comprises the support structure 2, the housing blocks 15 and 18 and the frame member 3 preferably made from synthetic material. More preferably, the support structure 2, the housing blocks 15 and 18 and the frame member 3 are partly made from recycable synthetic material. The advantage of using recycable material, for example plastic, is that 40% scrap can be used, whereby the production cost of a roof tile assembly can be controlled. Further, after the use of the solar roof tile assembly for the predetermined service life, the PV panel, support structure and housing block can be easily classified and separated, whereby excellent recycling property can be obtained. The material used is preferably UV-resistant, impact resistant and resistant to extreme temperature changes.
Preferably, and as illustrated in figure 17, the rear side of the support structure 2 has several recesses 30 whereby even less material needs to be used and yet, the strength of the structure kept optimal. Moreover, the weight of the roof structure is reduced, which is a more safe. As the weight of the roof tile assemblies is reduced, the transportation costs are also reduced. Preferably, the members are twin-shot injected resulting in material which is very strong, stiff, yet lightweight, which allows the roof tile assemblies to be used as the roof's finished surface. Co-injection or similar techniques can also be used. The color of the plastic can be adapted according to user's preferences. The material further allows better sound- and heat insulation. Using this material ensures millimeter accuracy in production, light weighted roof tile assemblies which allow accurate and easy placement and connection of the roof tile assemblies. Further, the synthetic material is resistant to moss and other herbal growth. By producing the housing blocks in such synthetic material, vermin is inhibited to find its way to the electrical connections, gnaw and destroy the cables, leading to short-circuit and possibly to fire.

Preferably, the support structure 2 comprises a first and a second cavity 11 and 12 providing two channels between with the top 13 and bottom side 14 of the support structure 2, as illustrated in figure 4. The cavities 11 and 12 allow natural ventilation. Outside air can passes under the photovoltaic panels to help cool them and increase the power generating efficiency of the panels. The channels allow for air current to enter the space between the support structure 2 and the photovoltaic panel 4 in the frame member 3. The air flow cools the backside of the photovoltaic panel 4, which increases the efficiency of the panel 4. Through the channels, the air then flows in the direction of the above laying solar roof tile assembly. Through an opening in the support structure of the top roof tile, the air is directed to an evaporator, which can be installed in the inner side of the closed roof top. The heat pump will hence receive warm air from the evaporator. This natural and/or induced ventilation increases the coefficient of performance (COP) of the heat pump with up to 10% and more.
Preferably, the roof tile assembly 1 is secured to the roof by a clamp to the gutter.

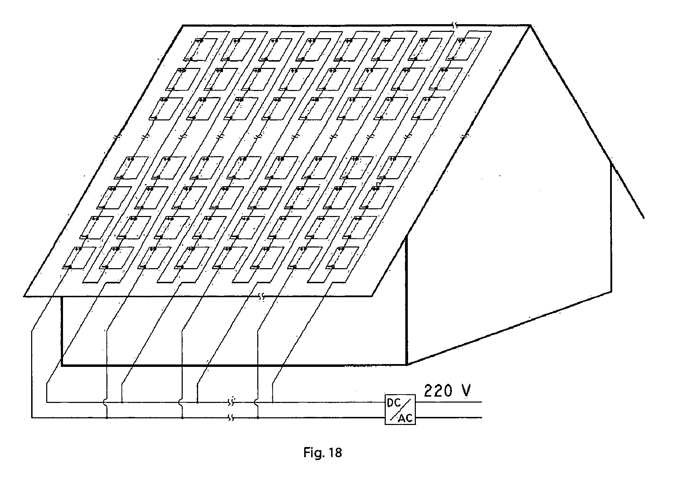

In a preferred embodiment, several rows, for example 20 solar roof tile assemblies are electrically connected to each other on the roof. In this way, a serial connection is formed. To close the electrical circuit between the adjacent rows of solar roof tile assemblies, only one wire is necessary to connect the roof tile assembly at the top of the row with the roof tile assembly at the bottom of the adjacent row and lead the current to flow in the same direction in all solar roof tile assemblies, as illustrated in figure 18. Wire tangling is hence impossible.

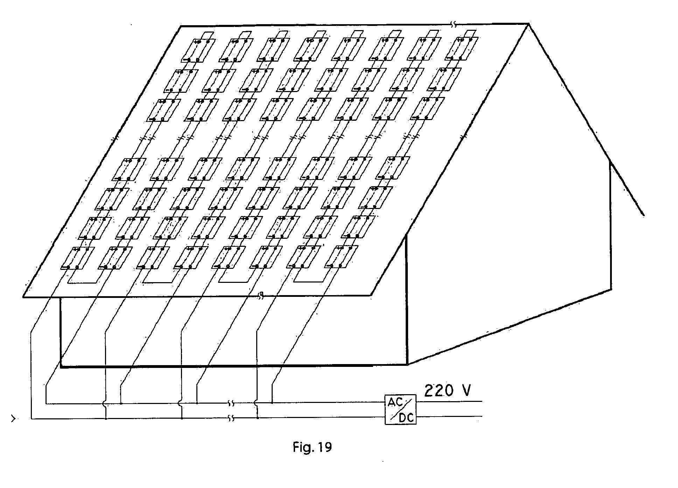

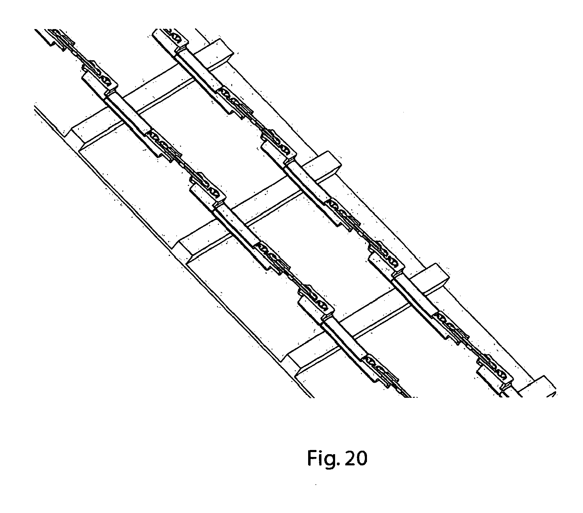

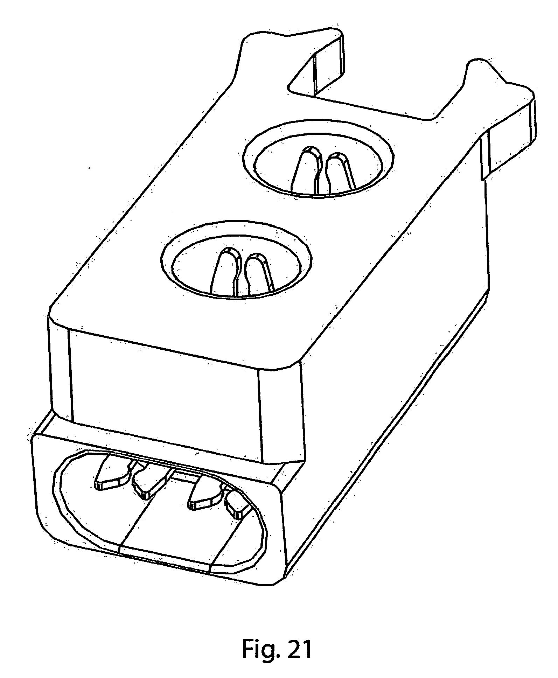

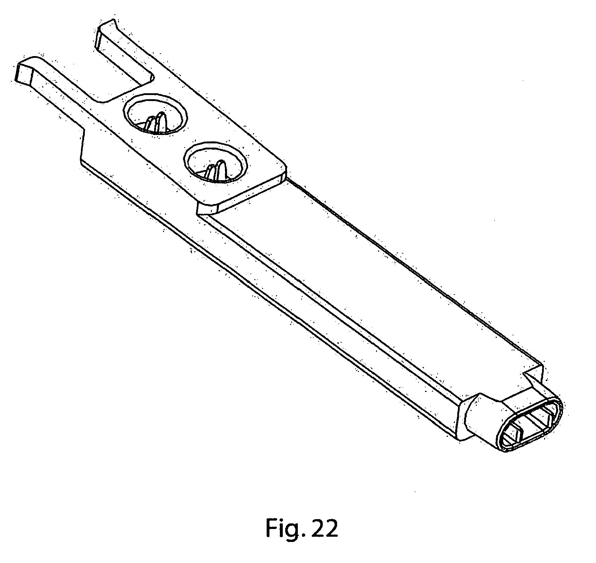

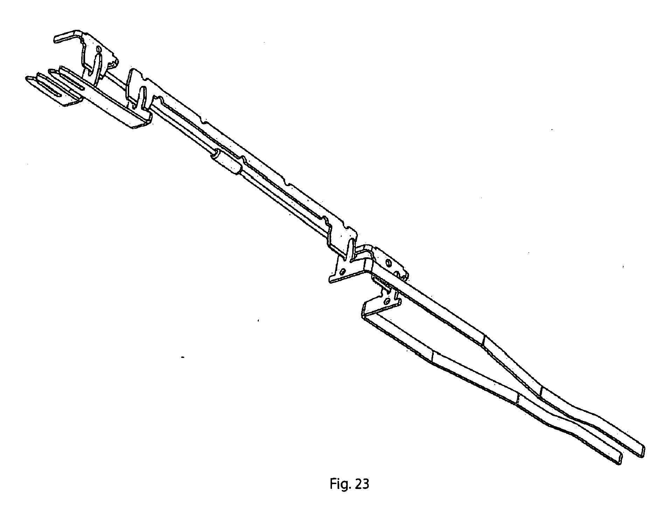

In another preferred embodiment, and as illustrated by figure 19 and more in detail illustrated in figures 20 to 23, a solar roof tile assembly is presented wherein the housing block comprises at least two busbars for providing electrical connection. The additional set of busbars in the housing block replaces the function of a cable, and forms hence an integrated connector. In a row of solar roof tile assemblies, the electrical charges flow through the connected busbars from the bottom of the row of solar roof tile assemblies to the top of the row. By providing a connection element, for example a bridge, at the top of the row to connect the pairs of busbars, the electrical charges can be guided further in the same top row roof tile assembly and hence, the electrical circuit is closed. An advantage of the present embodiment is that, as the additional set of busbars can be integrated in the roof tile assembly and replaces the cable, no wires are necessary on the roof nor in the roof tile assembly 1 and wire tangling on the roof is completely excluded.

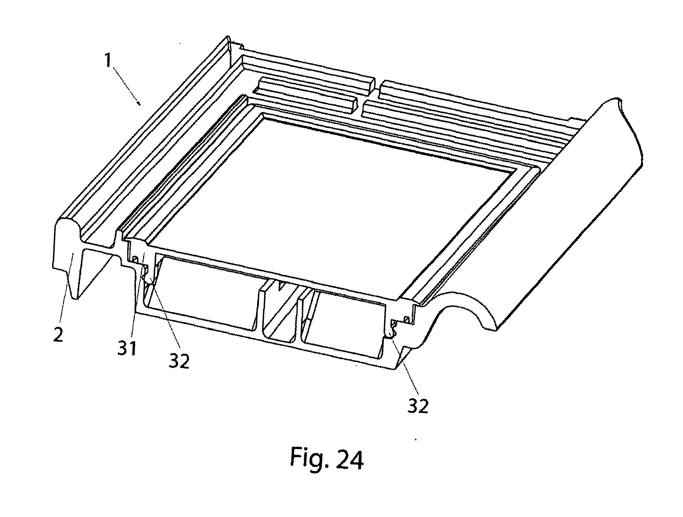

Another embodiment according to the invention and illustrated in figure 24 provides a roof tile assembly 1 comprising a support structure 2 and a closing panel 31 mounted on the support structure for closure of the assembly. The closing panel 31 is a panel snapped in the support structure 2 by means of a snap-shot system with clips 32. The closing panel 31 is preferably made from synthetic, water resistant material and is compatible with the support structure 2. The roof tile assemblies comprising the closing panel 31 are preferably place on the north side of the roof. In this way the entire roof can be covered with the same kind of roof tile assemblies, either with or without photovoltaic panels and the roof is more aesthetically appealing. Another advantage of the present invention is that incremental building of the solar roof is possible. If the budget for photovoltaic panels is not directly available, the support structure 2 is placed on the roof and closed with the closing panel 31. When the budget for photovoltaic panels is available, the closing panel 31 is removed and replaced by a frame member 3 comprising a photovoltaic panel 4. Extra costs of roof tiles which become useless when they are replaced by photovoltaic integrated roof tile assemblies are hence avoided. This can be done both in new buildings as well as in buildings to be renovated.

Another embodiment of the present invention is a multi-roof tile assembly spanning over a width and/or length of more than one conventional roof tile. The roof tile assembly is electrically connected to a circuit by means of at least one busbar structure.

The photovoltaic panels 4 of the roof tile assemblies 1 can be movable in the frame members 3 whereby the photovoltaic panels 4 are moved to capture an optimal amount of sunlight, thereby increasing their efficiency. More preferably, the photovoltaic panel 4 is covered by a synthetic or glass plate that bundles the light, for example according to the Fresnel effect. Another way to increase the efficiency of the roof tile assembly is by mounting reflectors on the support structure whereby the amount of sunlight captured is reflected and multiplied.

A person skilled in the art will understand that the examples described above are merely illustrative in accordance with the present invention and not limiting the intended scope of the invention. Other applications of the present invention may also be considered.

## Claims

1. A roof tile assembly (1) comprising a support structure (2) for supporting at least one photovoltaic panel (4), said support structure (2) comprising at least one housing block (15;18), **characterized in that** said housing block (15;18) comprises at least one busbar (20;23) for providing electrical connection.

2. A roof tile assembly (1) as defined in claim 1, whereby said housing block (15;18) is positioned longitudinally in said support structure (2).

3. A roof tile assembly (1) as defined in claim 1, whereby said housing block (15;18) is removable from said roof tile assembly (1).

4. A roof tile assembly (1) as defined in claim 3, whereby said housing block (15:18) is connected to the support structure (2) by means of a snap-shot system.

5. A roof tile assembly (1) as defined in claim 1, whereby said housing block (15;18) comprises at least two busbars for providing electrical connection.

6. A roof tile assembly (1) as defined in claim 1, whereby said photovoltaic panel (4) is removable from said roof tile assembly (1).

7. A roof tile assembly (1) as defined in claim 1, whereby at least one photovoltaic panel (4) is enclosed by a frame member (3), **characterized in that** said frame member (3) is engaged with the support structure (2) by means of a snap-shot system.

8. A roof tile assembly (1) as defined in claim 1, whereby the support structure (2) comprises at least one cavity (11; 12) for natural and/or induced ventilation.

9. A roof tile assembly (1) as defined in claim 1, whereby said busbar (20;23) is made of a conductive material having a resistivity lower than 7,5.10⁻⁷Ωm.

10. A roof tile assembly (1) as defined in claim 1 comprising a closing panel (31) mounted on the support structure (2) for closure of the assembly, **characterized in that** said closing panel (31) is removable.

11. A busbar structure (50) for electrically connecting one or more roof tile assemblies (1), said busbar structure comprising:
- a first rigid conductive circuit member (20), integrated in a first roof tile assembly (1);
- a second rigid conductive circuit member (23), integrated in a second roof tile assembly; and
- at least a third conductive circuit member (27) connected to an electrical generating device, **characterized in that** said first rigid conductive circuit member (20) and said second rigid conductive circuit member (23) are adapted for engaging to each other.

12. A busbar structure (50) as defined in claim 11, whereby at least one of the said first (20) and/or second (23) rigid conductive circuit members is enclosed in a housing block (15;18), **characterized in that** said housing block (15;18) is designed such to receive a third conductive circuit member (27) via a snap fit.

13. A busbar structure (50) according to claim 11, whereby at least one of the circuit members (20; 23; 27) is designed to be elastically and flexible to allow movement.

14. A busbar structure (50) according to claim 11 comprising an additional circuit conductive element (28).

15. The use of at least one busbar structure (50) as defined in claim 11 to 14 in a roof tile assembly (1) according to claim 1 to 10.

## Amended claims

### Amended claims in accordance with Rule 137(2) EPC.

**1.** A roof tile assembly (1) comprising a support structure (2) for supporting at least one photovoltaic panel (4), said support structure (2) comprising at least one housing block housing at least one busbar (20;23) for providing electrical connection (15;18), **characterized in that** said housing block (15;18) is positioned within said support structure (2).

**2.** A roof tile assembly (1) as defined in claim 1, whereby said housing block (15;18) is positioned longitudinally in said support structure (2).

**3.** A roof tile assembly (1) as defined in claim 1, whereby said housing block (15;18) is removable from said roof tile assembly (1).

**4.** A roof tile assembly (1) as defined in claim 3, whereby said housing block (15;18) is connected to the support structure (2) by means of a snap-shot system.

**5.** A roof tile assembly (1) as defined in claim 1, whereby said housing block (15; 18) comprises at least two busbars for providing electrical connection.

**6.** A roof tile assembly (1) as defined in claim 1, whereby said photovoltaic panel (4) is removable from said roof tile assembly (1).

**7.** A roof tile assembly (1) as defined in claim 1, whereby at least one photovoltaic panel (4) is enclosed by a frame member (3), **characterized in that** said frame member (3) is engaged with the support structure (2) by means of a snap-shot system.

**8.** A roof tile assembly (1) as defined in claim 1, whereby the support structure (2) comprises at least one cavity (11; 12) for natural and/or induced ventilation.

**9.** A roof tile assembly (1) as defined in claim 1, whereby said busbar (20;23) is made of a conductive material having a resistivity lower than 7,5.10⁻⁷Ωm.

**10.** A roof tile assembly (1) as defined in claim 1 comprising a closing panel (31) mounted on the support structure (2) for closure of the assembly, **characterized in that** said closing panel (31) is removable.

**11.** A set of roof tile assemblies according to claim 1 to 10, electrically connected by a busbar structure (50) for electrically connecting one or more roof tile assemblies (1), said busbar structure comprising:
- a first rigid conductive circuit member (20), integrated in a first roof tile assembly (1);
- a second rigid conductive circuit member (23), integrated in a second roof tile assembly; and
- at least a third conductive circuit member (27) connected to an electrical generating device, **characterized in that** said first rigid conductive circuit member (20) and said second rigid conductive circuit member (23) are adapted for engaging to each other.

**12.** A set of roof tile assemblies according to claim 1 to 10, electrically connected by a busbar structure (50) as defined in claim 11, whereby at least one of the said first (20) and/or second (23) rigid conductive circuit members is enclosed in a housing block (15;18), **characterized in that** said housing block (15;18) is designed such to receive a third conductive circuit member (27) via a snap fit.

**13.** A set of roof tile assemblies according to claim 1 to 10, electrically connected by a busbar structure (50) according to claim 11, whereby at least one of the circuit members (20; 23; 27) is designed to be elastically and flexible to allow movement.

**14.** A set of roof tile assemblies according to claim 1 to 10, electrically connected by a busbar structure (50) according to claim 11 comprising an additional circuit conductive element (28).

**15.** The use of a set of roof tile assemblies according to claim 1 to 10, electrically connected by at least one busbar structure (50) as defined in claim 11 to 14 in a roof tile assembly (1) according to claim 1 to 10.
